# EUROPÄISCHE PATENTSCHRIFT

(11) **EP 3 887 835 B1**
(45) Veröffentlichungstag und Bekanntmachung des Hinweises auf die Patenterteilung: **03.04.2024**
(21) Anmeldenummer: 20706965.9
(22) Anmeldetag: 12.02.2020
(51) Int. Cl.: G01R 31/327, G01R 31/26

(54) **VERFAHREN UND VORRICHTUNG ZUR AUTOMATISCHEN PRÜFUNG EINES SCHALTORGANS**
DEVICE AND METHOD FOR AUTOMATIC TESTING OF A SWITCHING BODY
DISPOSITIF ET PROCÉDÉ DE VÉRIFICATION AUTOMATIQUE D'UN ORGANE DE COMMUTATION

(30) Priorität: 15.02.2019 EP 19157462
(43) Veröffentlichungstag der Anmeldung: 06.10.2021
(73) Patentinhaber: Siemens Aktiengesellschaft, 80333 München (DE)
(72) Erfinder: SCHIERLING, Hubert, 91052 Erlangen (DE)
(74) Vertreter: Siemens Patent Attorneys
(86) Internationale Anmeldenummer: PCT/EP2020/053541
(87) Internationale Veröffentlichungsnummer: WO 2020/165213

(56) Entgegenhaltungen:
- DE-A1-102015 204 343
- DE-A1-102015 222 990
- US-A1- 2017 187 367

## Beschreibung

Die Erfindung betrifft eine Funktionsüberwachung eines Schaltorgans und insoweit ein Verfahren und eine Vorrichtung zur automatischen Prüfung einer Funktionsfähigkeit eines zumindest ein Schaltelement umfassenden Schaltorgans. Als Schaltorgan wird hier und im Folgenden ein Schalt- und Schutzorgan bezeichnet, nämlich ein Schalt- und Schutzorgan, welches einem an ein Stromnetz, insbesondere ein Gleichstromnetz, angeschlossenen Verbraucher oder einem Netzzweig/Lastbereich mit mehreren Verbrauchern vorgeschaltet ist. Ein solches Schalt- und Schutzorgan umfasst zumindest ein elektrisch schaltbares Schaltelement und trennt in einem Fehlerfall den Verbraucher oder den Lastbereich von der Speiseseite. Dies ist die Schutzfunktion des Schalt- und Schutzorgans. Genauso kann mittels des Schalt- und Schutzorgans auch durch einen auf das Schalt- und Schutzorgan wirkenden Schaltbefehl ein Abschalten des oder jedes an das Schalt- und Schutzorgan angeschlossenen Verbrauchers sowie des von dem Schalt- und Schutzorgan ausgehenden Lastbereichs bewirkt werden. Dies ist die Schaltfunktion des Schalt- und Schutzorgans.

Die Funktionsfähigkeit eines solchen Schaltorgans ist für die Verfügbarkeit eines Systems mit zumindest einem solchen Schaltorgan, also ein Stromnetz, insbesondere ein Gleichstromnetz, essenziell.

Bisher wird ein Versagen eines Schaltorgans als Restrisiko betrachtet. Es wird also in Kauf genommen, dass in einem Fehlerfall ein Großteil einer Anlage mit den an das jeweilige Stromnetz angeschlossenen Verbrauchern ausfällt, zum Beispiel weil aufgrund des Versagens eines Schaltorgans Schaltorgane parallel liegender Lastbereiche und/oder innerhalb des Stromnetzes hierarchisch höher positionierte Schaltorgane ansprechen.

Aus der DE 10 2015 204 343 A1 ist eine Vorrichtung bekannt, die einen Spannungsmesser und eine Verarbeitungseinrichtung umfasst. Der Spannungsmesser ist konfiguriert, um eine Spannung zwischen einem Steueranschluss und einem Leistungsanschluss eines halbleiterbasierten Schalters zu messen und um ein Messsignal zu erhalten. Die Verarbeitungseinrichtung ist ausgebildet, um das Messsignal mit einem Referenzsignal zu vergleichen, und um basierend auf dem Vergleich einen Zustand einer Schalteranordnung, die den halbleiterbasierten Schalter umfasst, zu bestimmen.

Eine Aufgabe der Erfindung besteht darin, ein Verfahren zur automatischen Prüfung einer Funktionsfähigkeit eines zumindest ein elektrisch schaltbares Schaltelement umfassenden Schaltorgans anzugeben. Eine Aufgabe der vorliegenden Erfindung besteht weiterhin darin, eine Vorrichtung zur automatischen Prüfung eines Schaltorgans, nämlich zur automatischen Prüfung einer Funktionsfähigkeit eines zumindest ein elektrisch schaltbares Schaltelement umfassenden Schaltorgans, anzugeben.

Diese Aufgabe wird mittels eines Prüfverfahrens mit den Merkmalen des Verfahrensanspruchs 1 gelöst. Diese Aufgabe wird mittels einer zur automatischen Prüfung einer Funktionsfähigkeit eines Schaltorgans bestimmten Prüfvorrichtung mit den Merkmalen des Vorrichtungsanspruchs 2 gelöst.

Bei dem Verfahren zum automatischen Prüfen einer Funktionsfähigkeit eines zumindest ein elektrisch schaltbares Schaltelement umfassenden Schaltorgans fungiert ein SiC-Leistungshalbleiter oder ein GaN-Leistungshalbleiter als Schaltelement. Ein Schaltzustand des oder jedes Schaltelements wird über einen Ansteuereingang des Schaltelements und mittels eines von einer Ansteuereinheit generierten und auf den Ansteuereingang ausgegebenen Ansteuersignals beeinflusst. Es wird ein Aktivierungssignal an die Ansteuereinheit ausgegeben wird, welches eine Veränderung des Ansteuersignals bewirkt, wobei das Aktivierungssignal als Veränderung des Ansteuersignals ein Prüfsignal und als Prüfsignal einen Abschaltpuls hervorruft. Dabei wird der SiC-Leistungshalbleiter oder GaN-Leistungshalbleiter mittels des Abschaltpulses abgeschaltet, während dieser in Rückwärtsrichtung Strom führt. Der sich in Reaktion auf den Abschaltpuls einstellende Spannungsabfall über den SiC-Leistungshalbleiter oder GaN-Leistungshalbleiter wird erfasst. Es wird ein Vergleich zwischen einem den erfassten Spannungsabfall über den SiC-Leistungshalbleiter oder GaN-Leistungshalbleiter kodierenden Kennzeichen und einer eine erwartete Reaktion auf den Abschaltpuls kodierenden Referenz durchgeführt. In Abhängigkeit vom Ergebnis des Vergleichs wird ein Statussignal generiert, welches die Funktionsfähigkeit des Schaltorgans kodiert.

Ein Vorteil der vorliegenden Erfindung liegt darin, dass bei einem Schaltorgan mit zumindest einem SiC- oder GaN-Leistungshalbleiter als Schaltelement der Strom in Rückwärtsrichtung durch das Schaltelement fließen kann und der Spannungsabfall über das Schaltelement davon abhängt, ob das Schaltelement angesteuert ist oder nicht. Bei einem SiC-MOSFET als Schaltelement fließt der Strom in Rückwärtsrichtung im angesteuerten Zustand über den Kanal, ansonsten über die Bodydiode. Der Spannungsabfall über der Bodydiode eines SiC-MOSFET liegt bei 3 V und ist damit deutlich höher als der Spannungsabfall über den Kanal des MOSFET, übliche Auslegung vorausgesetzt. Der Spannungsabfall an einem GaN-Transistor liegt in diesem Fall bei ca. 5 V bis 10 V. Dabei ist es besonders vorteilhaft, dass diese Spannungen von der Höhe des in Rückwärtsrichtung fließenden Stromes nur wenig abhängen.

Im Rahmen der Prüfung werden die Stromrichtung und der Spannungsabfall über dem Schaltelement ausgewertet. Der Transistor, der in Rückwärtsrichtung Strom führt, erhält einen Abschaltpuls. Nun können zwei unterschiedliche Fälle auftreten. Fall 1: Der Transistor ist funktionsfähig und somit steuerbar, hier: abschaltbar; dadurch kommutiert der Strom auf die intrinsische Bodydiode des SiC-MOSFET bzw. führt bei einem GaN-Transistor zu einem höheren Spannungsabfall. Fall 2: Der Transistor ist nicht steuerbar, hier: nicht abschaltbar; somit bleibt der Spannungsabfall über dem SiC- oder GaN-Leistungshalbleiter konstant. Der nach einem Abschaltpuls vorliegende Spannungsabfall wird mittels einer Auswerteeinheit geprüft. Daher bietet die Erfindung eine Prüfung einer Funktionsfähigkeit, die während des laufenden Betriebs erfolgen kann, d. h. während eines nicht unterbrochenen Stromflusses durch den SiC- oder GaN-Leistungshalbleiter. Da der Stromfluss aufrechterhalten bleibt, existiert auch kein zeitlicher Druck, dass die Prüfung einer Funktionsfähigkeit schnell beendet wird. Die vorliegende Erfindung erlaubt es somit, eine Prüfung einer Funktionsfähigkeit ohne Zeitdruck durchzuführen. Außerdem ist die durch eine Messung zu bestimmende, am Transistor anliegende Spannung mit einem Wertebereich von 3 bis 10 Volt für eine einfache und eindeutige Erfassung ausreichend hoch.

Für SiC-MOSFETs, die wegen ihres geringen Durchlasswiderstands für die Anwendung in einem Schaltorgan der hier beschriebenen Art besonders gut geeignet sind, ist somit unabhängig von der Stromrichtung immer eine Prüfung jedes Schaltelements möglich. Auch bei einem GaN-Leistungshalbleiter als Schaltelement kann der Strom in Rückwärtsrichtung fließen, und der Spannungsabfall ist in diesem Betriebsfall bei einem am Ansteuereingang des GaN-Leistungshalbleiters anliegendem Ein-Signal kleiner als bei keinem am Ansteuereingang des GaN-Leistungshalbleiters anliegendem Ein-Signal. GaN-Leistungshalbleiter verhalten sich somit ähnlich wie SiC-MOSFETs und können in gleicher Weise überwacht werden.

Das Schaltorgan umfasst zumindest ein elektrisch schaltbares Schaltelement. Das Schaltorgan umfasst als Schaltelement elektrisch schaltbare Leistungshalbleiterschalter. Ein Schaltzustand des oder jedes Schaltelements ist über einen Ansteuereingang des Schaltelements und mittels eines von einer Ansteuereinheit generierbaren und auf den Ansteuereingang ausgegebenen Ansteuersignals beeinflussbar und wird beim Betrieb des Schaltorgans mittels eines von der Ansteuereinheit generierten und auf den Ansteuereingang ausgegebenen Ansteuersignals beeinflusst; das Schaltelement wird mittels des Ansteuersignals in einen geöffneten oder geschlossenen Zustand geschaltet.

Bezüglich der zur automatischen Prüfung einer Funktionsfähigkeit eines Schaltorgans bestimmten Prüfvorrichtung, d. h. einer Vorrichtung zur Durchführung des Verfahrens zur automatischen Prüfung einer Funktionsfähigkeit eines zumindest ein Schaltelement umfassenden Schaltorgans, wobei ein SiC-Leistungshalbleiter oder ein GaN-Leistungshalbleiter als Schaltelement fungiert, im Folgenden als Prüfvorrichtung bezeichnet, ist vorgesehen, dass mittels der Prüfvorrichtung ein Aktivierungssignal an die Ansteuereinheit ausgebbar ist, welches eine Veränderung des Ansteuersignals bewirkt, dass mittels der Prüfvorrichtung, insbesondere mittels einer Messeinheit, eine Reaktion auf ein verändertes Ansteuersignal erfassbar ist, dass mittels der Prüfvorrichtung, insbesondere mittels einer Auswerteeinheit, ein Vergleich zwischen einem die erfasste Reaktion auf das veränderte Ansteuersignal kodierenden Kennzeichen und einer eine erwartete Reaktion auf das veränderte Ansteuersignal kodierenden Referenz durchführbar ist und dass mittels der Prüfvorrichtung, insbesondere mittels der Auswerteeinheit, in Abhängigkeit vom Ergebnis des Vergleichs ein Statussignal generierbar ist, welches die Funktionsfähigkeit des Schaltorgans kodiert.

Im Detail ist vorgesehen, dass die Prüfvorrichtung so ausgebildet ist, dass ein Schaltzustand des oder jedes Schaltelements über einen Ansteuereingang des Schaltelements und mittels eines von einer Ansteuereinheit generierbaren und auf den Ansteuereingang ausgegebenen Ansteuersignals beeinflussbar ist, mittels der Prüfvorrichtung ein Aktivierungssignal an die Ansteuereinheit ausgebbar ist, welches eine Veränderung des Ansteuersignals bewirkt, wobei das Aktivierungssignal als Veränderung des Ansteuersignals ein Prüfsignal und als Prüfsignal einen Abschaltpuls hervorruft, wobei der SiC-Leistungshalbleiter oder GaN-Leistungshalbleiter mittels des Abschaltpulses abschaltbar ist, während dieser in Rückwärtsrichtung Strom führt, wobei mittels der Prüfvorrichtung als Reaktion auf den Abschaltpuls der Spannungsabfall über dem SiC-Leistungshalbleiter oder GaN-Leistungshalbleiter erfassbar ist, wobei mittels der Prüfvorrichtung ein Vergleich zwischen einem den erfassten Spannungsabfall über dem SiC-Leistungshalbleiter oder GaN-Leistungshalbleiter kodierenden Kennzeichen und einer eine erwartete Reaktion auf das veränderte Ansteuersignal kodierenden Referenz durchführbar ist und wobei mittels der Prüfvorrichtung in Abhängigkeit vom Ergebnis des Vergleichs ein Statussignal generierbar ist, welches die Funktionsfähigkeit des Schaltorgans kodiert. Dabei ist die Prüfvorrichtung eingerichtet, den SiC-Leistungshalbleiter oder GaN-Leistungshalbleiter mittels des Abschaltpulses abzuschalten, während dieser in Rückwärtsrichtung Strom führt.

Es ist möglich, dass bei einer Prüfung ein Schaltelement bei einem Stromfluss in Vorwärtsrichtung nicht komplett abgeschaltet, sondern das Ansteuersignal so geändert wird, dass eine reduzierte Ansteuerspannung resultiert (zum Beispiel 10 V anstelle von 15 V). In diesem Fall steigt der Spannungsabfall über dem Schaltelement (zum Beispiel von 1 V auf 3 V). Ein solcher Anstieg ist die auf die abgesenkte Ansteuerspannung erwartete Reaktion und die tatsächliche Spannung über dem Schaltelement wird mit einer die erwartete Reaktion kodierenden Referenz, zum Beispiel einem Schwellwert von 2 V, verglichen. Der Vorteil einer solchen Prüfung besteht darin, dass der Strom während der Prüfung weiterhin fließen kann. Aus diesem Grunde ist auch die Rückwirkung aufgrund der Prüfung auf die Lastseite geringer. Dies erlaubt eine längere Zeit zum Messen, also zur messtechnischen Erfassung der erwarteten Reaktion.

Das Verfahren (Prüfverfahren) wird bevorzugt mittels einer Prüfvorrichtung wie hier und im Folgenden beschrieben ausgeführt. Bei einem solchen mittels der Prüfvorrichtung ausgeführten Verfahren wird mittels der Prüfvorrichtung ein Aktivierungssignal an die Ansteuereinheit ausgegeben, welches eine Veränderung des Ansteuersignals bewirkt. Weiter wird mittels der Prüfvorrichtung, insbesondere mittels einer Messeinheit, eine Reaktion auf ein verändertes Ansteuersignal erfasst. Ferner wird mittels der Prüfvorrichtung, insbesondere mittels einer Auswerteeinheit, ein Vergleich zwischen einem die erfasste Reaktion auf das veränderte Ansteuersignal kodierenden Kennzeichen und einer eine erwartete Reaktion auf das veränderte Ansteuersignal kodierenden Referenz durchgeführt. Schließlich wird mittels der Prüfvorrichtung, insbesondere mittels der Auswerteeinheit, in Abhängigkeit vom Ergebnis des Vergleichs ein Statussignal generiert, welches die Funktionsfähigkeit des Schaltorgans kodiert.

Die Prüfvorrichtung wirkt mit dem zu prüfenden Schaltorgan zusammen und ist optional Bestandteil des Schaltorgans, zum Beispiel indem die Prüfvorrichtung mit der Ansteuereinheit des Schaltorgans kombiniert ist. Ein solches Schaltorgan weist zumindest ein elektrisch schaltbares Schaltelement der oben genannten Art, eine Ansteuereinheit und eine Prüfvorrichtung wie hier und im Folgenden beschrieben auf. Ein Schaltzustand des oder jedes Schaltelements ist über einen Ansteuereingang des Schaltelements und mittels eines von einer Ansteuereinheit generierbaren und auf den Ansteuereingang ausgegebenen Ansteuersignals beeinflussbar. Mittels der Prüfvorrichtung ist ein Aktivierungssignal an die Ansteuereinheit ausgebbar, welches eine Veränderung des Ansteuersignals bewirkt. Ebenfalls mittels der Prüfvorrichtung, insbesondere mittels einer Messeinheit, ist eine Reaktion auf ein verändertes Ansteuersignal erfassbar. Weiterhin mittels der Prüfvorrichtung, insbesondere mittels einer Auswerteeinheit, ist ein Vergleich zwischen einem die erfasste Reaktion auf das veränderte Ansteuersignal kodierenden Kennzeichen und einer eine erwartete Reaktion auf das veränderte Ansteuersignal kodierenden Referenz durchführbar. Schließlich ist mittels der Prüfvorrichtung, insbesondere mittels der Auswerteeinheit, in Abhängigkeit vom Ergebnis des Vergleichs ein Statussignal generierbar, welches die Funktionsfähigkeit des Schaltorgans kodiert.

Ein wesentlicher Vorteil der Erfindung besteht darin, dass die Möglichkeit einer zuverlässigen Beurteilung der Funktionsfähigkeit eines Schaltorgans und des oder zumindest eines davon umfassten Schaltelements geschaffen wird. Durch die Prüfung können beispielsweise Ausfälle aufgrund von Alterung, spontanem Versagen von Bauelementen oder Überbeanspruchung, zum Beispiel durch zu hohe Temperatur oder Spannung, eines Schaltorgans frühzeitig erkannt werden. Dies verhindert Schäden durch Folgefehler oder Produktionsausfälle aufgrund des Versagens der Schutz- oder Schaltfunktion, erhöht die Verfügbarkeit einer an ein Stromnetz angeschlossenen elektrischen Anlage und kann zudem die zeitlichen Abstände zwischen Wartungsintervallen steigern.

Ein weiterer Vorteil der Erfindung besteht darin, dass die Prüfung im laufenden Betrieb durchgeführt werden kann. Es besteht also keine Notwendigkeit, für eine Prüfung eines Schaltorgans den oder jeden daran angeschlossenen Verbraucher abzuschalten. Eine im laufenden Betrieb durchgeführte Prüfung des Schaltorgans kann auch als Überwachung des Schaltorgans bezeichnet werden.

Bei der Prüfvorrichtung oder dem Prüfverfahren ist mittels der Prüfvorrichtung ein Aktivierungssignal an die Ansteuereinheit ausgebbar bzw. wird ein Aktivierungssignal an die Ansteuereinheit ausgegeben, welches als Veränderung des Ansteuersignals ein Prüfsignal und als Prüfsignal einen Abschaltpuls hervorruft. Mittels eines solchen Prüfsignals wird das damit beaufschlagte Schaltelement für die Dauer des Abschaltpulses abgeschaltet (geöffnet; in den nicht-leitenden Zustand geschaltet). Dies ist ein definierter Zustand des Schaltelements, welcher bei einer bestimmungsgemäßen Funktion des Schaltelements eine vorhersehbare Reaktion auf den Abschaltpuls hervorruft. Eine solche vorhersehbare Reaktion ist zum Beispiel ein Aufbau einer Potentialdifferenz über dem mittels des Abschaltpulses abgeschalteten Schaltelement. Eine solche Potentialdifferenz oder ein Aufbau einer solchen Potentialdifferenz ist als Spannung über dem Schaltelement bzw. als Spannungsänderung über dem Schaltelement messtechnisch erfassbar und wird bei einer entsprechenden Ausführungsform im Rahmen des Prüfverfahrens oder mittels der Prüfvorrichtung, zum Beispiel der Messeinheit, erfasst.

Der SiC-Leistungshalbleiter oder der GaN-Leistungshalbleiter als Schaltelement wird im Rahmen des Prüfverfahrens mittels eines Abschaltpulses abgeschaltet, während dieser in Rückwärtsrichtung Strom führt. Als Reaktion auf den Abschaltpuls wird der Spannungsabfall über dem SiC-Leistungshalbleiter erfasst, und es wird ein Vergleich zwischen einem den erfassten Spannungsabfall über dem SiC-Leistungshalbleiter oder dem GaN-Leistungshalbleiter kodierenden Kennzeichen und einer eine erwartete Reaktion auf den Abschaltpuls kodierenden Referenz durchgeführt. In Abhängigkeit vom Ergebnis des Vergleichs wird ein Statussignal generiert, welches die Funktionsfähigkeit des mit dem Abschaltpuls beaufschlagten Schaltelements und damit auch die Funktionsfähigkeit des Schaltorgans insgesamt kodiert. In einem nicht erfindungsgemäßen Fall, dass ein SiC-Leistungshalbleiter, ein IGBT oder ein GaN-Leistungshalbleiter als Schaltelement mittels eines Abschaltpulses abgeschaltet wird, während dieser in Vorwärtsrichtung Strom führt, wird als Reaktion auf den Abschaltpuls eine Spannung oder eine Spannungsänderung über dem SiC-Leistungshalbleiter, dem IGBT bzw. dem GaN-Leistungshalbleiter erfasst, und es wird ein Vergleich zwischen einem die erfasste Spannung oder Spannungsänderung kodierenden Kennzeichen und einer eine erwartete Reaktion auf den Abschaltpuls kodierenden Referenz durchgeführt. Auch hier wird in Abhängigkeit vom Ergebnis des Vergleichs ein Statussignal generiert, welches die Funktionsfähigkeit des mit dem Abschaltpuls beaufschlagten Schaltelements und damit auch die Funktionsfähigkeit des Schaltorgans insgesamt kodiert.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das Ausführungsbeispiel ist nicht als Einschränkung der Erfindung zu verstehen. Vielmehr sind im Rahmen der vorliegenden Offenbarung durchaus auch Ergänzungen und Modifikationen möglich, insbesondere solche, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen
- FIG 1: ein Schaltorgan mit hier zwei elektrisch schaltbaren Schaltelementen, einer Ansteuereinheit sowie einer zur Prüfung des Schaltorgans, nämlich zumindest eines Schaltelements, bestimmten Prüfvorrichtung,
- FIG 2: ein elektrisches Netz mit einer Mehrzahl von Schaltorganen, insbesondere Schaltorganen gemäß FIG 1,
- FIG 3: ein Beispiel für ein mittels der Ansteuereinheit ausgebbares Ansteuersignal sowie eine mittels der Prüfvorrichtung bewirkbare Veränderung des Ansteuersignals, wobei die Veränderung des Ansteuersignals als Prüfsignal zur Prüfung des Schaltorgans fungiert, und
- FIG 4: eine schematisch vereinfachte Darstellung eines Verfahrens zur Prüfung eines Schaltorgans gemäß FIG 1 oder eines Schaltorgans mit zumindest einem elektrisch schaltbaren Schaltelement.

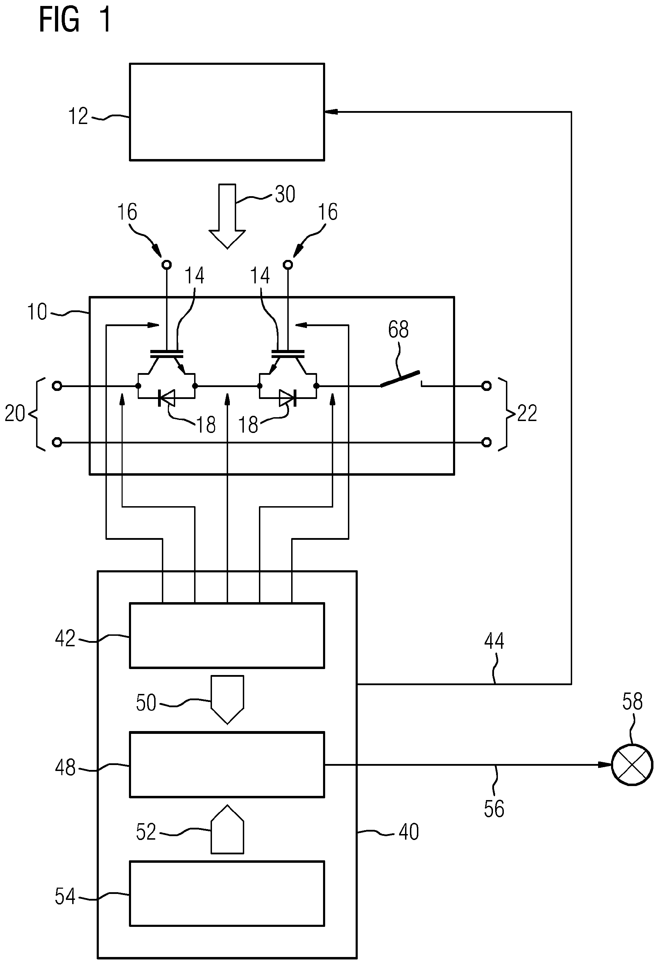

Die Darstellung in FIG 1 zeigt beispielhaft und schematisch vereinfacht ein im Folgenden kurz als Schaltorgan 10 bezeichnetes Schalt- und Schutzorgan 10 der eingangs genannten Art zusammen mit einer von dem Schaltorgan 10 umfassten oder (wie gezeigt) einer dem Schaltorgan 10 funktional zugeordneten Ansteuereinheit 12.

Das Schaltorgan 10 umfasst zumindest ein elektrisch ansteuerbares Schaltelement 14, zum Beispiel in Form eines elektrisch ansteuerbaren Halbleiterschalters 14, insbesondere in Form eines Leistungshalbleiterschalters 14. Ein jeweiliger Schaltzustand (leitend, nicht leitend) des oder jedes Schaltelements 14 ist über einen Ansteuereingang 16 des Schaltelements 14 beeinflussbar.

Die Darstellung in FIG 1 zeigt eine grundsätzlich optionale Konfiguration, bei welcher dem oder jedem Schaltelement 14 eine entgegen dessen Durchlassrichtung leitende Diode 18 zugeordnet ist, entweder als integraler Bestandteil des das Schaltelement 14 umfassenden Bauteils (Bodydiode) oder als zusätzliches Bauteil (Anti-Parallel-Diode).

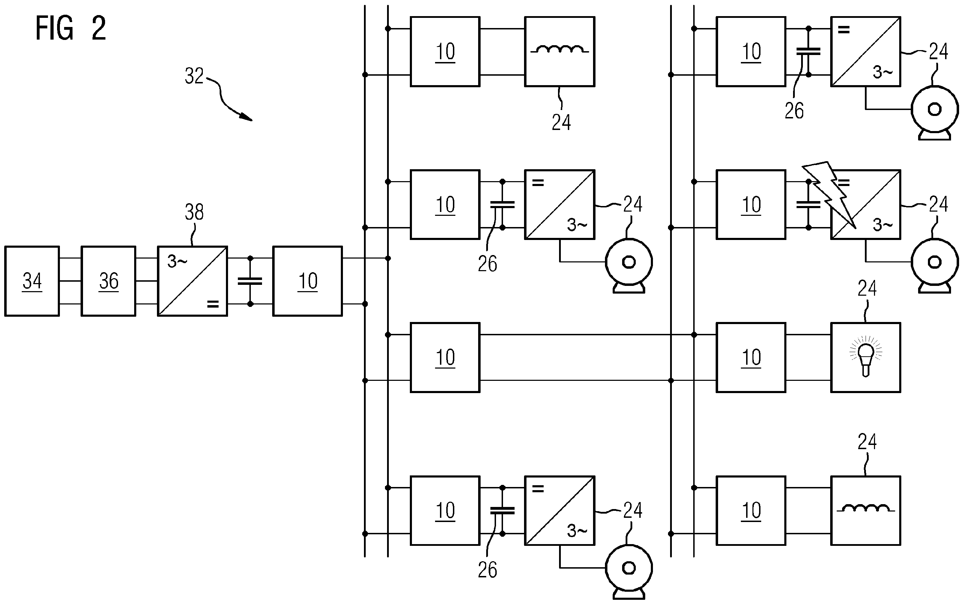

Auf einer durch Eingangskontakte gebildeten Eingangsseite 20 (Eingang 20) ist das Schaltorgan 10 an eine Versorgungsspannung, insbesondere eine Gleichspannung, anschließbar und im Betrieb an eine Versorgungsspannung angeschlossen. Auf einer durch Ausgangskontakte gebildeten Ausgangsseite 22 (Ausgang 22) ist an das Schaltorgan 10 (unmittelbar oder mittelbar) eine Last 24 (FIG 2) anschließbar und zum Betrieb der Last 24 ist diese an das Schaltorgan 10 angeschlossen, insbesondere über einen an der Ausgangsseite 22 des Schaltorgans 10 angeschlossenen Kondensator 26 (FIG 2), welcher ggf., zum Beispiel bei Antrieben, auch Teil der Last 24 sein kann.

Mittels zumindest eines in der Darstellung in FIG 1 nur schematisch vereinfacht in Form eines Blockpfeils gezeigten Ansteuersignals 30 ist das Schaltorgan 10 ansteuerbar. Das oder jedes Ansteuersignal 30 wird im Betrieb von der Ansteuereinheit 12 erzeugt. Bei der gezeigten Ausführungsform umfasst das Schaltorgan 10 zwei antiserielle Schaltelemente 14. Bei einem Schaltorgan 10 mit mehr als einem Schaltelement 14 gibt die Ansteuereinheit 12 für jedes Schaltelement 14 ein Ansteuersignal 30 aus und jedes Ansteuersignal 30 liegt am Ansteuereingang 16 eines Schaltelements 14 an. Bei einem Ansteuersignal 30, welches bei einem Schaltorgan 10 mit zwei Schaltelementen 14 beide Schaltelemente 14 in einen elektrisch leitenden Zustand versetzt, ist das Schaltorgan 10 insgesamt bidirektional leitend. Bei einem Ansteuersignal 30, welches bei einem Schaltorgan 10 mit zwei Schaltelementen 14 genau eines der Schaltelemente 14 in einen elektrisch leitenden Zustand versetzt, ist das Schaltorgan 10 unidirektional leitend. Anstelle eines Schaltorgans 10 mit zwei antiseriellen Schaltelementen 14 kommt grundsätzlich auch ein Schaltorgan 10 mit genau einem Schaltelement 14 in Betracht. Bei einem Ansteuersignal 30, welches bei einem solchen Schaltorgan 10 dessen Schaltelement 14 in einen elektrisch leitenden Zustand versetzt, ist das Schaltorgan 10 in der durch die Art und den Anschluss des jeweiligen Schaltelements 14 bestimmten Richtung leitend.

Bei jeder Erwähnung eines Schaltorgans 10 sind im Folgenden eine Ausführung mit genau einem Schaltelement 14 und ebenso eine Ausführung mit mehr als einem Schaltelement 14, insbesondere mit genau zwei Schaltelementen 14, mitzulesen.

Im Interesse einer besseren Lesbarkeit der weiteren Beschreibung wird diese auf Basis genau eines Ansteuersignals 30 fortgesetzt. Dieses ist entweder ein Ansteuersignal 30 für das genau eine Schaltelement 14 eines entsprechenden Schaltorgans 10 oder die Gesamtheit aller Ansteuersignale 30 für jedes von einem jeweiligen Schaltorgan 10 umfasste Schaltelement 14.

Die Darstellung in FIG 2 zeigt eine Mehrzahl von Schaltorganen 10, insbesondere Schaltorgane 10 wie oben im Zusammenhang mit der Erläuterung der Darstellung in FIG 1 beschrieben, in einer beispielhaften Netzkonfiguration eines im Folgenden kurz als Netz 32 bezeichneten Gleichspannungsnetzes 32, welches exemplarisch zwei Netzebenen umfasst. Das Netz 32 geht von einem Wechselspannungsnetz 34, einem nachfolgenden Wechselspannungsschalt- und -schutzelement 36 und einem wiederum daran anschließenden Gleichrichter 38 aus.

Das Netz 32 umfasst in jeder Netzebene verschiedene Lastbereiche, die jeweils durch eine Last 24 (Verbraucher) veranschaulicht sind. Als Last 24 sind in der Darstellung in FIG 2 exemplarisch Antriebe mit einem vorgeschalteten Wechselrichter, eine Beleuchtung und Heizeinrichtungen gezeigt. Grundsätzlich kann in einem Lastbereich auch mehr als eine Last 24 (mehr als ein Verbraucher) angeschlossen sein. Bei der gezeigten Konfiguration ist (in grundsätzlich optionaler Art und Weise) jeder Lastbereich mittels eines Schaltorgans 10 der oben im Zusammenhang mit der Erläuterung der Darstellung in FIG 1 beschriebenen Art abgesichert. Bei der gezeigten Konfiguration befindet sich (in grundsätzlich optionaler Art und Weise) auch zwischen den Netzebenen ein solches Schaltorgan 10. Ebenso befindet sich (in grundsätzlich optionaler Art und Weise) ein solches Schaltorgan 10 im Anschluss an den Gleichrichter 38 und fungiert dort gewissermaßen als Einspeisepunkt des Gleichspannungsnetzes 32.

Zum Trennen eines Lastbereichs vom restlichen Netz 32 wird das jeweilige Schaltorgan 10 mit einem Ansteuersignal 30 (Fig. 1) angesteuert, welches einen Schaltzustand des Schaltorgans 10 bewirkt, bei dem auf der Ausgangsseite 22 eine an der Eingangsseite 20 anliegende Spannung verschwindet; das Schaltorgan ist elektrisch "offen". Dies wird im Folgenden als Öffnen des Schaltorgans 10 bezeichnet. Ein automatisches Öffnen des Schaltorgans 10 erfolgt beispielsweise dann, wenn mittels einer in der Darstellung in FIG 1 nicht gezeigten (an sich bekannten) Sensorik automatisch eine Überstrom- oder Fehlerstromsituation erkannt wird. Ein Öffnen des Schaltorgans 10 kann auch aufgrund eines externen Signals ausgelöst werden, wenn ein Lastbereich abgeschaltet werden soll.

Im fehlerfreien Fall wird zur Ankopplung eines Lastbereichs an ein Netz 32 das jeweilige Schaltorgan 10 mit einem Ansteuersignal 30 angesteuert, welches einen Schaltzustand des Schaltorgans 10 bewirkt, bei dem eine an der Eingangsseite 20 anliegende Spannung an der Ausgangsseite 22 erscheint; das Schaltorgan ist elektrisch "geschlossen". Dies wird im Folgenden als Schließen des Schaltorgans 10 bezeichnet.

Ob zum Öffnen oder Schließen eines Schaltorgans 10 ein "hohes" oder ein "niedriges" oder ein positives oder ein negatives Potential erforderlich ist und jeweils bestimmungsgemäß als Ansteuersignal 30 von der Ansteuereinheit 12 erzeugt wird, hängt in grundsätzlich an sich bekannter Art und Weise von der Art und dem Anschluss des oder jedes Schaltelements 14 ab. Vereinfachend wird im Folgenden von einem Ansteuersignal 30 zum Schließen eines Schaltorgans 10 oder einem Ansteuersignal 30 zum Öffnen eines Schaltorgans 10 gesprochen.

In der Darstellung in FIG 2 ist mittels eines "Blitzes" symbolisch ein Fehler in einem Lastbereich des Netzes 32 dargestellt. Als Fehler ist zum Beispiel ein Kurzschluss in einem Verbraucher 24 denkbar. Im Falle eines Fehlers muss das dem betroffenen Lastbereich zugeordnete Schaltorgan 10 den Lastbereich sicher vom restlichen Netz 32 trennen. Dafür wird das Schaltorgan 10 mit einem Ansteuersignal 30 zum Öffnen des Schaltorgans 10 angesteuert. Wenn das Schaltorgan 10 nicht ordnungsgemäß arbeitet und trotz eines solchen Ansteuersignals 30 das Schaltorgan 10 nicht öffnet, ist eine sichere Trennung des von einem Fehler betroffenen Lastbereichs vom restlichen Netz 32 nicht gewährleistet. Ohne eine solche Trennung des von dem Fehler betroffenen Lastbereichs sind im Falle eines Kurzschlusses alle parallel liegenden Lastbereiche ebenfalls kurzgeschlossen und verlieren ihre Funktionsfähigkeit. Eine ordnungsgemäße Funktion eines jeden Schaltorgans 10 in einem jeweiligen Netz 32 ist also für dessen sicheren und dauerhaft belastbaren Betrieb essenziell.

Zur Prüfung eines Schaltorgans 10, insbesondere eines jeden Schaltorgans 10 in einem Netz 32 mit einer Mehrzahl von Verbrauchern (Last 24) und/oder einer Mehrzahl von Lastbereichen und/oder einer Mehrzahl von Netzebenen, ist eine Prüfvorrichtung 40 (Fig. 1) vorgesehen. Die Prüfvorrichtung 40 ist optional - anders als in der schematisch vereinfachten Darstellung in FIG 1 gezeigt - in die Ansteuereinheit 12 integriert.

Mittels der Prüfvorrichtung 40, nämlich einer von der Prüfvorrichtung 40 umfassten oder der Prüfvorrichtung 40 zugeordneten Messeinheit 42, wird zumindest ein charakteristischer elektrischer Messwert in Bezug auf das Schaltorgan 10 aufgenommen. Ein Beispiel für einen charakteristischen Messwert ist ein Spannungsmesswert, welcher über dem, einem oder jedem von dem Schaltorgan 10 umfassten Schaltelement 14 erfasst wird. Weitere Beispiele sind Spannungsmesswerte an einem Eingang oder einem Ausgang des Schaltelements 14 oder eines Schaltelements 14 oder am Ansteuereingang 16 des Schaltelements 14 oder eines Schaltelements 14. Die möglichen Messungen mittels der Messeinheit 42 sind in der Darstellung in FIG 1 schematisch vereinfacht mittels von der Messeinheit 42 ausgehenden und zu einzelnen möglichen Messpunkten weisender Pfeile veranschaulicht. Alternativ zu Spannungsmessungen, dazu gehören optional auch Messungen von Spannungsverläufen, erfolgen mittels der Messeinheit 42 optional auch Strommessungen, insbesondere Messungen von Stromverläufen. Optional erfolgen mittels der Messeinheit 42 Strom- und Spannungsmessungen, insbesondere Messungen von Strom- und Spannungsverläufen.

In der Regel werden die erforderlichen Messwerte bereits von Sensoren erfasst, die der Ansteuereinheit 12 zugeordnet sind. Die Messung durch die Messeinheit 42 erfolgt in diesem Fall durch Zugriff auf diese Messwerte.

Die Messung mittels der Messeinheit 42 erfolgt unter Kontrolle der Prüfvorrichtung 40. Die Messung erfolgt in zeitlichem Zusammenhang mit einer von der Prüfvorrichtung 40 ausgelösten Veränderung eines von der Ansteuereinheit 12 ausgegebenen Ansteuersignals 30. Eine Messung (Überwachung des Schaltorgans 10) in zeitlichen Zusammenhang mit der Veränderung des Ansteuersignals 30 bedeutet dabei eine kontinuierliche Messung oder eine Messung vor, während und/oder nach der Veränderung des Ansteuersignals 30, insbesondere während der Veränderung des Ansteuersignals 30.

Zur Veränderung des Ansteuersignals 30 ist die Prüfvorrichtung 40 mit der Ansteuereinheit 12 verbunden. In der Darstellung in FIG 1 ist dies schematisch vereinfacht in Form eines Signalpfads von der Prüfvorrichtung 40 zur Ansteuereinheit 12 gezeigt. Über diesen gibt die Prüfvorrichtung 40 ein Aktivierungssignal 44 an die Ansteuereinheit 12 aus. Mittels des Aktivierungssignals 44 aktiviert die Prüfvorrichtung 40 bei der Ansteuereinheit 12 eine Veränderung des Ansteuersignals 30. Die Veränderung des Ansteuersignals 30 aufgrund eines von der Prüfvorrichtung 40 ausgegebenen Aktivierungssignals 44 erfolgt dabei während des Betriebs des Schaltorgans 10, also dann, wenn keine Schalthandlung (wegen Kurzschluss oder wegen eines Schaltbefehls von außen) erforderlich ist und entsprechend ansonsten durch die Ansteuereinheit 12 ein konstantes Ansteuersignal 30 ("Ein-Signal") ausgegeben würde.

Alternativ zu einem solchen Aktivierungssignal 44, welches auf Seiten der Ansteuereinheit 12 die Veränderung des Ansteuersignals 30 auslöst, kommt auch in Betracht, dass die Prüfvorrichtung 40 selbst die Veränderung des Ansteuersignals 30 auslöst. Dann umfasst die Ansteuereinheit 12 zum Beispiel eine regelbare Spannungsquelle und als Aktivierungssignal 44 wird eine mittels der Spannungsquelle erzeugte Spannung, insbesondere ein mittels der Spannungsquelle erzeugter Spannungsverlauf, dem von der Ansteuereinheit 12 erzeugten Ansteuersignal 30 überlagert.

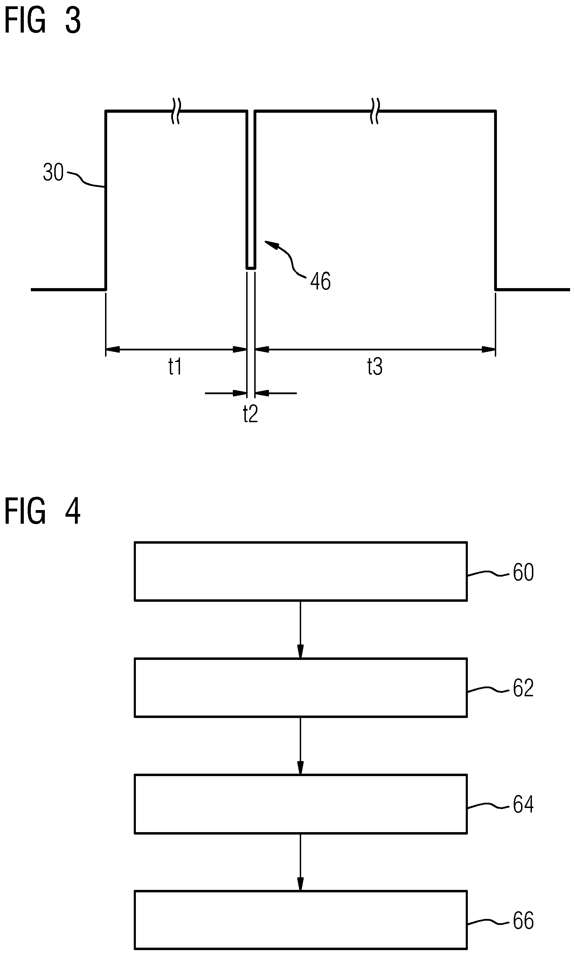

Aufgrund der automatisch mittels des Aktivierungssignals 44 ausgelösten Veränderung des Ansteuersignals 30 resultiert ein Prüfsignal 46 (Fig. 3), zum Beispiel ein Prüfsignal 46 in Form eines kurzen Abschaltpulses 46. Das Prüfsignal 46, insbesondere ein Abschaltpuls 46 als Prüfsignal 46, beeinflusst den Zustand (leitend, nicht-leitend) des oder jedes Schaltelements 14 des Schaltorgans 10.

Die Darstellung in FIG 3 zeigt beispielhaft einen zeitlichen Verlauf eines Ansteuersignals 30. In einem ersten Zeitabschnitt t1 bewirkt dieses ein Schließen des Schaltorgans 10. In einem zweiten Zeitabschnitt t2 wirkt das Aktivierungssignal 44. Dort kommt es zu der durch das Aktivierungssignal 44 bewirkten Veränderung des Ansteuersignals 30. Die Veränderung des Ansteuersignals 30 ist bei der gezeigten Situation ein Prüfsignal 46 in Form eines kurzen Abschaltpulses 46. Im Anschluss daran folgt in einem dritten Zeitabschnitt t3 wieder das "normale", unveränderte Ansteuersignal 30. Während der Dauer eines Ansteuersignals 30 kann - anders als in der schematisch vereinfachten Darstellung in FIG 3 gezeigt - das Aktivierungssignal 44 mehr als einmal wirken, zum Beispiel zu vorgegebenen oder vorgebbaren, insbesondere äquidistanten oder zufällig (quasi-zufällig) gewählten Zeitpunkten.

Die weitere Beschreibung wird anhand eines Prüfsignals 46 in Form eines kurzen Abschaltpulses 46 (wie in FIG 3 gezeigt) fortgesetzt, welcher als Ergebnis einer mittels des Aktivierungssignals 44 ausgelösten Veränderung des Ansteuersignals 30 resultiert. Des Weiteren wird davon ausgegangen, dass jede Last 24 elektrische Leistung aufnimmt, der Strom also in die Last 24 hineinfließt. Der umgekehrte Fall (andere Stromrichtung; anderes Stromvorzeichen) ist natürlich ebenso möglich und entsprechend stets mitzulesen.

Bei einem Kondensator 26 am Ausgang 22 des Schaltorgans 10 wird dieser bei geschlossenem Schaltorgan 10 geladen und bei vollständiger Ladung steht am Ausgang 22 des Schaltorgans 10 die an dessen Eingang 20 anliegende Spannung an. Beim Prüfen des Schaltorgans 10 mittels eines aufgrund des Aktivierungssignals 44 resultierenden Abschaltpulses 46 wird das Schaltorgan 10, nämlich das Schaltelement 14 oder das in Stromflussrichtung geschaltete Schaltelement 14, während der Dauer des Abschaltpulses 46 geöffnet. Bei geöffnetem Schaltorgan 10 wird eine angeschlossene Last 24 zumindest kurzzeitig aus dem Kondensator 26 gespeist. Der resultierende Ladungsabfluss aus dem Kondensator 26 ruft eine elektrische Spannung über dem ausgeschalteten Schaltelement 14 hervor. Ein Anstieg der Spannung über dem ausgeschalteten Schaltelement 14 und/oder eine momentane Spannung über dem ausgeschalteten Schaltelement 14 sind mittels der Messeinheit 42 erfassbar.

Ein zur Prüfung des Schaltorgans 10 aufgrund des Aktivierungssignals 44 resultierender Abschaltpuls 46 ist so kurz bemessen, dass die Spannungsänderung "klein" bleibt. Eine aufgrund des Abschaltpulses 46 resultierende kleine Spannungsänderung bedeutet dabei, dass die Spannungsänderung keinen Einfluss (zumindest keinen merklichen Einfluss) auf den Betrieb einer Last 24 hat, welche an das in dieser Weise angesteuerte Schaltorgan 10 angeschlossen ist. Die aufgrund des Abschaltpulses 46 resultierende kleine Spannungsänderung ist aber so groß, dass sie mittels der Messeinheit 42 detektierbar ist. Die Spannungsänderung ist also zumindest ein wenig höher als eine Auflösung der Spannungsmessung mittels der Messeinheit 42.

Bei einer solchen Situation wird zur Prüfung des Schaltorgans 10, nämlich zur Prüfung des ausgeschalteten Schaltelements 14, als charakteristischer elektrischer Messwert in Bezug auf das Schaltorgan 10 die aufgrund des Abschaltpulses 46 resultierende Spannung oder Spannungsänderung erfasst. Der Messwert wird mittels einer von der Prüfvorrichtung 40 umfassten oder der Prüfvorrichtung 40 zugeordneten Auswerteeinheit 48 ausgewertet. Dafür wird von der Messeinheit 42 an die Auswerteeinheit 48 ein Kennzeichen 50 übermittelt. Das Kennzeichen 50 beschreibt die detektierte Spannung oder Spannungsänderung, zum Beispiel in Form eines während der Spannungsänderung aufgetretenen Extremwerts. Das Kennzeichen 50 wird mittels der Auswerteeinheit 48 mit einer Referenz 52 verglichen. Die Referenz 52 ist aus einem der Prüfvorrichtung 40 zugeordneten oder von der Prüfvorrichtung 40 umfassten Speicher 54 abrufbar und wird dort zum Vergleich mit dem Kennzeichen 50 abgerufen. Die Referenz 52 ist zum Beispiel vorgegeben, also dem Speicher 54 unveränderbar eingeprägt. Alternativ kann die Referenz 52 auch vorgebbar sein, also durch eine einem Verwender des Schaltorgans 10 zugängliche Parametrisierung im Speicher 54 veränderbar sein.

Bei dem vorstehend beschriebenen Beispiel, bei dem vor und nach der Wirkung des Abschaltpulses 46 bei einem ordnungsgemäß funktionierenden Schaltelement 14 (also einem aufgrund des Ansteuersignal 30 geschlossenen Schaltelement 14) davon ausgegangen werden kann, dass über diesem nur eine kleine durch die Durchlasseigenschaften bestimmte Spannung ansteht, und weiterhin davon ausgegangen werden kann, dass während der Wirkung des Abschaltpulses 46 die Spannung über dem durch den Abschaltpuls 46 geöffneten Schaltelement 14 ansteigt, kommt als Referenz 52 zum Beispiel ein Datum in Betracht, welches einen Spannungswert von 3 V kodiert. Das Ansteigen der Spannung über dem geöffneten Schaltelement 14 erfasst man zum Beispiel, indem man die Differenz zwischen der Spannung vorher und der Spannung im ausgeschalteten Betrieb (geöffnetes Schaltelement 14) bildet. Diese Differenz müsste dann wenigstens 1 V sein. Beim Vergleich eines die momentane Spannung über dem durch den Abschaltpuls 46 geöffneten Schaltelement 14 kodierenden Kennzeichens 50 mit einer solchen Referenz 52 ist der Vergleich zum Beispiel als "größer oder gleich"-Vergleich implementiert und sobald die Spannung über dem durch den Abschaltpuls 46 geöffneten Schaltelement 14 die durch die Referenz 52 kodierte Schwelle erreicht oder überschreitet, ist die Funktionsfähigkeit des mit dem Abschaltpuls 46 beaufschlagten Schaltelements 14 festgestellt.

Das Kennzeichen 50, welches eine aufgrund eines Aktivierungssignals 44 resultierende Spannung oder Spannungsänderung und/oder die oder jede sonst mittels der Messeinheit 42 erfassbare elektrische Größe kodiert, kann ein einzelner Wert sein, also zum Beispiel ein (Spannungs-), ein (Spannungs-), eine Flankensteilheit, eine Anstiegs- oder Abstiegszeit usw. Dann ist das Kennzeichen 50 ein einzelnes Datum, also ein Kennwert, und die bei dem Vergleich berücksichtigte Referenz 52 ist entsprechend ein Referenzwert. Das Kennzeichen 50 (und entsprechend auch die Referenz 52) kann auch mehr als ein Datum umfassen, zum Beispiel eine Kombination der oben genannten Werte oder sonstige Werte, welche ein mittels der Messeinheit 42 im zeitlichen Zusammenhang mit der Veränderung des Ansteuersignals 30 aufgenommenes elektrisches Signal beschreiben.

Bei dem mittels der Auswerteeinheit 48 automatisch ausgeführten Vergleich kommt es darauf an, ob die aufgrund der Veränderung des Ansteuersignals 30 resultierende Veränderung zumindest einer mittels der Messeinheit 42 erfassbaren elektrischen Größe in einem erwarteten Bereich liegt. Die Größe könnte auch der Strom sein. Nach dem Abschalten muss der Strom unmittelbar null werden.

Die bei dem Vergleich mittels der Auswerteeinheit 48 zugrunde gelegte Referenz 52 kodiert den erwarteten Bereich oder allgemein das, was aufgrund der Veränderung des Ansteuersignals 30 (aufgrund des Prüfsignals 46) bei einem ordnungsgemäß funktionierenden Schaltorgan 10 als Reaktion auf die Veränderung des Ansteuersignals 30 erwartet wird. Die Referenz 52 basiert entsprechend zum Beispiel auf im Betrieb bei einem ordnungsgemäß funktionierenden Schaltorgan 10 aufgenommenen Werten, zum Beispiel Spannungswerten. Optional werden bei einer solchen Bildung der Referenz 52 verschiedene ordnungsgemäß funktionierende Schaltorgane 10 berücksichtigt, so dass sich als Referenz 52 zumindest ein Wertebereich ergibt. Zusätzlich oder alternativ können die Referenz 52 oder zumindest ein als Referenz 52 fungierender Wertebereich auch empirisch ermittelt werden, zum Beispiel mittels eines Modells des Schaltorgans 10 oder des oder jedes davon umfassten Schaltelements 14. Allgemein formuliert wird zur Funktionsprüfung des Schaltorgans 10 mittels der Auswerteeinheit 48 und durch den Vergleich von Kennzeichen 50 und Referenz 52 eine erwartete Korrelation zwischen dem veränderten Ansteuersignal 30 und der zumindest einen mittels der Messeinheit 42 erfassten elektrischen Größe geprüft.

Zur Ausführung des Vergleichs von Kennzeichen 50 und Referenz 52 umfasst die Auswerteeinheit 48 zum Beispiel zumindest einen Komparator (nicht gezeigt) oder eine entsprechende Funktionseinheit oder eine entsprechende Funktionalität in Soft- und/oder Firmware. Optional umfasst die Auswerteeinheit 48 eine Implementation komplexerer Auswertungsregeln, so dass zum Beispiel für den Fall, dass der Strom in Rückwärtsrichtung über einen zu prüfenden SiC-Leistungshalbleiter fließt, Auswertungen wie folgt durchgeführt werden können:
Wenn {[(U-U1) > K1] oder [((U-U1) > Uref) und (t > t1)]} dann [S1 auf High setzen; Prüfsignal zurücksetzen; wenn (S2 = High) dann (S auf High setzen) ansonsten (S1 unverändert lassen; S unverändert lassen)]
ansonsten
   {wenn [(t > K2*I) oder (t > tmax)]
   dann (S1 auf Low setzen; S auf Low setzen; Prüfsignal zurücksetzen)
   ansonsten (S1 nicht verändern; Prüfsignal nicht verändern)}
wobei:
   U: gemessene Spannung über dem Schalter (zwischen Source und Drain), d.h. Spannungsabfall über dem Schalter
   U1: U vor Aktivierung des Prüfsignals
   K1: Konstante, z.B. 5 V
   Uref: Referenzspannung, z.B. 1 V
   t: Zeit seit Aktivierung des Prüfsignals
   t1: Wartezeit, z.B. 20 ps
   tmax: Maximaldauer des Prüfsignals, z.B. 1 ms
   S: Statussignal (High bedeutet, dass das Schaltorgan in Ordnung ist)
   S1: Status des zu prüfenden Schalters
   S2: Status des anderen Schalters im Schaltorgan
   K2: Konstante, z.B. 10 ps/A
   I: Strom im Schaltorgan (von Source zu Drain)

Als Ergebnis des Vergleichs gibt die Auswerteeinheit 48 ein Statussignal 56 aus. Bei einer Gleichheit oder einer zumindest ausreichenden Gleichheit von Kennzeichen 50 und Referenz 52 - oder allgemein im Falle einer erfüllten, in der Auswerteeinheit 48 implementierten Bedingung - gibt die Auswerteeinheit 48 ein Statussignal 56 aus, welches ein ordnungsgemäß funktionierendes Schaltorgan 10 kodiert. Bei einer Ungleichheit oder einer nicht ausreichenden Gleichheit von Kennzeichen 50 und Referenz 52 - oder allgemein im Falle einer nicht erfüllten, in der Auswerteeinheit 48 implementierten Bedingung - gibt die Auswerteeinheit 48 ein Statussignal 56 aus, welches ein nicht ordnungsgemäß funktionierendes Schaltorgan 10 kodiert. Mittels des Statussignals 56 kann zum Beispiel ein Signalelement 58 angesteuert werden, welches einen Benutzer über die Funktionsfähigkeit des Schaltorgans 10 informiert, zum Beispiel ein optisches Signalelement, insbesondere eine Status-LED, und/oder ein akustisches Signalelement. Zusätzlich oder alternativ kann das Statussignal 56 auch an eine (nicht gezeigte) übergeordnete Einheit, zum Beispiel eine Einheit zur Überwachung des jeweiligen Netzes 32 und der davon umfassten Schaltorgane 10, weitergleitet und dort ausgewertet werden. Eine dortige Auswertung des Statussignals 56 umfasst beispielsweise eine Statusanzeige entsprechend dem Statussignal 56 auf einem Bildschirm oder dergleichen.

Als Schaltelement(e) 14 eines Schaltorgans 10 kommt grundsätzlich jeder Halbleiterschalter, insbesondere Leistungshalbleiter, in Betracht, zum Beispiel MOSFETs, IGBTs usw.

Bei IGBTs als Schaltelement 14, nämlich IGBTs mit antiparalleler Diode (Anti-Parallel-Diode 18), wird die Prüfung durchgeführt, wenn der Strom in Vorwärtsrichtung (d.h. über den IGBT) fließt. Wenn der IGBT aufgrund eines entsprechenden Aktivierungssignals 44 und mittels eines resultierenden Abschaltpulses 46 abgeschaltet wird, steigt die Spannung über dem Schaltelement 14 und dem Schaltorgan 10 insgesamt - wie oben beschrieben - an, weil in einem DC-Netz auf beiden Seiten des Schaltorgans 10 Kapazitäten liegen, zum Beispiel die Kapazität des am Ausgang 22 des Schaltorgans 10 liegenden Kondensators 26. Die Spannung steigt mit endlicher Geschwindigkeit. Die Dauer eines aufgrund des Aktivierungssignals 44 resultierenden Abschaltpulses 46 wird so kurz bemessen, dass die Spannungsänderung klein (nur wenig höher als der Auflösungsbereich der Spannungsmessung) bleibt.

Das für IGBTs als Schaltelement 14 beschriebene Verfahren ist auch bei allen Arten von Leistungshalbleitern anwendbar, insbesondere auch für SiC-MOSFETs.

Bei einem Schaltorgan 10 mit zumindest einem SiC-Leistungshalbleiter (Siliziumcarbid-Halbleiter) als Schaltelement 14 kann der Strom in Rückwärtsrichtung über die Diode 18 (Bodydiode) und/oder den Kanal des in Rückwärtsrichtung geschalteten MOSFETs fließen. Letzteres ist nur dann der Fall, wenn der MOSFET eingeschaltet ist. Ein Stromfluss über den MOSFET führt zu geringeren Verlusten (einer geringeren Spannung über dem Schaltelement 14) als ein Stromfluss über die Bodydiode, weil die Durchlassspannung der Bodydiode, d.h. der Spannungsabfall über die Bodydiode, bei 3 V liegt und damit deutlich höher ist als die des MOSFETs (übliche Auslegung vorausgesetzt). Im Rahmen der Prüfung werden die Stromrichtung und der Spannungsabfall über das Schaltelements 14 ausgewertet. Der MOSFET, der gerade in Rückwärtsrichtung Strom führt, wird aufgrund eines entsprechenden Aktivierungssignals 44 und mittels eines resultierenden Abschaltpulses 46 abgeschaltet. Wenn der MOSFET steuerbar ist, steigt der Spannungsabfall über den MOSFET dadurch auf 3 V an. Wenn der Ansteuerkanal defekt ist oder der MOSFET einen Kurzschluss hat oder nicht leitend ist, bleibt sie konstant. Dies wird mittels der Auswerteeinheit 48 wie oben beschrieben geprüft. Dabei genügt die Erfassung des gesamten Spannungsabfalls über zwei wie in FIG 1 gezeigt in Reihe geschaltete Schaltelemente 14 durch Messung über den beiden Schaltelementen 14 oder durch Bildung der Differenz einer am Eingang 20 und am Ausgang 22 gemessenen Spannung. Die Anforderung an die absolute Genauigkeit der Spannungserfassung ist gering, weil nur die Änderung der Spannung ausgewertet werden muss.

Für SiC-MOSFETs, die wegen ihres geringen Durchlasswiderstands für die Anwendung in einem Schaltorgan 10 der hier beschriebenen Art besonders gut geeignet sind, ist somit unabhängig von der Stromrichtung immer eine Prüfung jedes Schaltelements 14 möglich.

Auch bei GaN-Schaltern kann der Strom in Rückwärtsrichtung fließen, und der Spannungsabfall ist in diesem Betriebsfall bei anliegendem Ein-Signal kleiner. Sie verhalten sich somit ähnlich wie SiC-MOSFETs und können in gleicher Weise überwacht werden.

Anstelle des in FIG 3 exemplarisch gezeigten Abschaltpulses 46 kommt als Prüfsignal 46 grundsätzlich jedes Signal in Betracht, welches bei korrekter Funktion des Schaltorgans 10 eine messbare Veränderung einer mittels der Messeinheit 42 erfassbaren elektrischen Größe bewirkt.

Mittels einer optionalen Messung des Stroms durch das Schaltorgan 10 stehen weitere Informationen zur Verfügung, die als Ergebnis einer automatischen Auswertung in Form eines Vergleichs eines entsprechenden Kennzeichens 50 mit einer Referenz 52 einen Rückschluss auf eine ggf. komplexwertige, zeitliche Widerstandscharakteristik und somit die Funktionsfähigkeit des Schaltorgans 10 zulassen. Zum Beispiel wird beim Abschalten eines in Vorwärtsrichtung leitenden Schaltelements 14 der Strom unmittelbar null. Sollte dies nicht der Fall sein und weiterhin ein messbarer Strom fließen, liegt bezüglich des gemessenen Stroms eine Abweichung von einem erwarteten Bereich vor. Die Strommessung erfolgt mittels eines beispielsweise von der Messeinheit 42 umfassten Strommessers (nicht gezeigt). Optional ist mehr als ein Strommesser vorhanden, so dass eine Strommessung an mehreren Messpunkten möglich ist, zum Beispiel an einigen oder allen der in der Darstellung in FIG 1 für die zuvor erläuterte Spannungsmessung erwähnten Messpunkten.

Je nach Charakteristik des oder jedes Schaltelements 14 weisen die Daten der Spannungs- und Strommessung eine unterschiedlich starke Korrelation auf, so dass die Messdaten einzeln und/oder zusammen als Basis für eine verbesserte Bestimmung der Funktionsfähigkeit des Schaltorgans 10 fungieren können. Eine Plausibilisierung erfolgt zum Beispiel in Form eines Vergleichs von Spannungs- und Strommesswerten. Da praktisch jede mittelbar oder unmittelbar an ein Schaltorgan 10 angeschlossene Last 24 kapazitiven Charakter aufweist, ist mit einer zeitlichen Änderung der Spannung eine Änderung des Stroms und mit einer zeitlichen Änderung des Stroms eine Spannungsänderung verbunden. Eine fehlende erwartungsgemäße Korrelation deutet auf ein nicht ordnungsgemäß funktionierendes Schaltorgan 10 hin. Eine erwartungsgemäße Korrelation wird mittels der Referenz 52 abgebildet.

Folglich werden durch multiple Messdaten von unterschiedlichen Messungen Fehler in einer Messung oder einer Messstelle durch Auswertung detektierbar und somit die Messungen gegenseitig plausibilisiert.

Die Prüfung - also die Auslösung des Aktivierungssignals 44, die Erfassung zumindest einer elektrischen Größe im zeitlichen Zusammenhang mit dem Aktivierungssignal 44 und durch die Messeinheit 42 sowie der Vergleich von Kennzeichen 50 und Referenz 52 - kann von der Prüfvorrichtung 40 selbsttätig ausgelöst und durchgeführt werden. Zusätzlich oder alternativ kann eine solche Prüfung extern durch eine entsprechende Ansteuerung der Prüfvorrichtung 40 initiiert werden. In beiden Fällen kann die Prüfung regelmäßig, zum Beispiel zu vorgegebenen oder vorgebbaren, insbesondere äquidistanten Zeitpunkten, oder zufällig (quasi-zufällig) ausgelöst werden.

Die Darstellung in FIG 4 zeigt abschließend beispielhaft ein Ablaufdiagramm des hier vorgeschlagenen Verfahrens zur automatischen Prüfung eines zumindest ein Schaltelement 14 umfassenden und zum Schutz in einem elektrischen Netz 32 bestimmten Schaltorgans 10. Das Verfahren ist zum Beispiel in Hardware oder in Firmware, zum Beispiel mittels eines FPGA oder dergleichen, oder in Firm- und Software oder in Software implementiert.

In einem ersten Schritt 60 wird das Aktivierungssignal 44 ausgelöst. Das Aktivierungssignal 44 bewirkt - wie oben beschrieben - eine Veränderung des bisher von der Ansteuereinheit 12 ausgegebenen Ansteuersignals 30. In einem zweiten Schritt 62 werden eine Reaktion auf das veränderte Ansteuersignal 30 und/oder Auswirkungen des veränderten Ansteuersignals 30 auf das Schaltelement 14 oder zumindest ein Schaltelement 14 erfasst. Beides wird zusammenfassend als Reaktion bezeichnet. Die Erfassung der Reaktion erfolgt mittels der Messeinheit 42. In einem dritten Schritt 64 erfolgt eine Bewertung der Reaktion. Die Bewertung erfolgt mittels der Auswerteeinheit 48, indem ein die tatsächliche Reaktion kodierendes Kennzeichen 50 mit einer eine erwartete Reaktion kodierenden Referenz 52 verglichen wird. In einem vierten Schritt 66 wird in Abhängigkeit vom Ergebnis des Vergleichs zum Beispiel ein Statussignal 56 erzeugt, welches optional an eine übergeordnete Einheit weitergeleitet wird.

Eine im vierten Schritt 66 durch die Prüfvorrichtung 40 in Abhängigkeit vom Ergebnis des Vergleichs ausgelöste Reaktion kann auch eine Abschaltung des Schaltorgans 10, zum Beispiel durch eine entsprechende Ansteuerung des oder jedes Schaltelements 14 und/oder durch das Öffnen eines weiteren Schalters 68 des Schaltorgans 10, umfassen. Fehler werden beispielsweise über eine Anzeige an der Prüfvorrichtung 40 und/oder über eine Geräteschnittstelle (Klemmleiste, Feldbus, optisches Signal) gemeldet. Bei einem detektierten Fehler kann der betroffene Lastbereich automatisch deaktiviert (Pulssperre bzw. Abschalten aller Verbraucher 24) und freigeschaltet werden.

Abschließend lässt sich der hier vorgeschlagene Ansatz kurz wie folgt zusammenfassen: Angegeben ein Verfahren zur automatischen Prüfung einer Funktionsfähigkeit eines zumindest ein elektrisch schaltbares Schaltelement 14 umfassenden Schaltorgans 10, insbesondere als Verfahren zum Betrieb der Prüfvorrichtung 40 oder des eine Prüfvorrichtung 40 umfassenden Schaltorgans 10. Als Prüfvorrichtung wird eine Vorrichtung zur Durchführung des Verfahrens bezeichnet, wobei die Prüfvorrichtung 40 zur automatischen Prüfung einer Funktionsfähigkeit eines zumindest ein elektrisch schaltbares Schaltelement 14 umfassenden Schaltorgans 10 dient. Bei dem Schaltorgan 10 ist ein Schaltzustand des oder jedes Schaltelements 14 über einen Ansteuereingang 16 des Schaltelements 14 und mittels eines von einer Ansteuereinheit 12 generierbaren und auf den Ansteuereingang 16 ausgegebenen Ansteuersignals 30 beeinflussbar. Im Rahmen des Verfahrens, insbesondere mittels der Prüfvorrichtung 40, ist ein Aktivierungssignal 44 an die Ansteuereinheit 12 ausgebbar, welches eine Veränderung des Ansteuersignals 30 bewirkt. Im Rahmen des Verfahrens, insbesondere mittels der Prüfvorrichtung 40, ist eine Reaktion auf ein verändertes Ansteuersignal 30 erfassbar. Weiter ist im Rahmen des Verfahrens, insbesondere mittels der Prüfvorrichtung 40, ein Vergleich zwischen einem die erfasste Reaktion auf das veränderte Ansteuersignal 30 kodierenden Kennzeichen 50 und einer eine erwartete Reaktion auf das veränderte Ansteuersignal 30 kodierenden Referenz 52 durchführbar. Schließlich ist im Rahmen des Verfahrens, insbesondere mittels der Prüfvorrichtung 40, in Abhängigkeit vom Ergebnis des Vergleichs ein Statussignal 56 generierbar und ausgebbar, welches die Funktionsfähigkeit des Schaltorgans 10 kodiert. Das Statussignal 56 oder ein aufgrund des Statussignals 56 angesteuertes Signalelement 58 oder dergleichen zeigt die Funktionsfähigkeit des Schaltorgans 10 an.

## Patentansprüche

1. Verfahren zum automatischen Prüfen einer Funktionsfähigkeit eines zumindest ein elektrisch schaltbares Schaltelement (14) umfassenden Schaltorgans (10),
wobei ein Schaltzustand des oder jedes Schaltelements (14) über einen Ansteuereingang (16) des Schaltelements (14) und mittels eines von einer Ansteuereinheit (12) generierten und auf den Ansteuereingang (16) ausgegebenen Ansteuersignals (30) beeinflusst wird,
wobei ein Aktivierungssignal (44) an die Ansteuereinheit (12) ausgegeben wird, welches eine Veränderung des Ansteuersignals (30) bewirkt, wobei das Aktivierungssignal (44) als Veränderung des Ansteuersignals (30) ein Prüfsignal (46) und als Prüfsignal (46) einen Abschaltpuls (46) hervorruft, wobei als Reaktion auf den Abschaltpuls (46) der Spannungsabfall über dem Schaltelement (14) erfasst wird,
wobei ein Vergleich zwischen einem den erfassten Spannungsabfall über dem Schaltelement (14) kodierenden Kennzeichen (50) und einer eine erwartete Reaktion auf den Abschaltpuls (46) kodierenden Referenz (52) durchgeführt wird, und
wobei in Abhängigkeit vom Ergebnis des Vergleichs ein Statussignal (56) generiert wird, welches die Funktionsfähigkeit des Schaltorgans (10) kodiert,
**dadurch gekennzeichnet,**
**dass** ein SiC-Leistungshalbleiter oder ein GaN-Leistungshalbleiter als Schaltelement (14) fungiert, wobei der SiC-Leistungshalbleiter oder GaN-Leistungshalbleiter mittels des Abschaltpulses (46) abgeschaltet wird, während dieser in Rückwärtsrichtung Strom führt.

2. Prüfvorrichtung (40) zur automatischen Prüfung einer Funktionsfähigkeit eines zumindest ein elektrisch schaltbares Schaltelement (14) umfassenden Schaltorgans (10),
wobei ein Schaltzustand des oder jedes Schaltelements (14) über einen Ansteuereingang (16) des Schaltelements (14) und mittels eines von einer Ansteuereinheit (12) generierbaren und auf den Ansteuereingang (16) ausgegebenen Ansteuersignals (30) beeinflussbar ist,
wobei mittels der Prüfvorrichtung (40) ein Aktivierungssignal (44) an die Ansteuereinheit (12) ausgebbar ist, welches eine Veränderung des Ansteuersignals (30) bewirkt, wobei das Aktivierungssignal (44) als Veränderung des Ansteuersignals (30) ein Prüfsignal (46) und als Prüfsignal (46) einen Abschaltpuls (46) hervorruft,
wobei mittels der Prüfvorrichtung (40) als Reaktion auf den Abschaltpuls (46) der Spannungsabfall über dem Schaltelement (14) erfassbar ist,
wobei mittels der Prüfvorrichtung (40) ein Vergleich zwischen einem den erfassten Spannungsabfall über dem Schaltelement (14) kodierenden Kennzeichen (50) und einer eine erwartete Reaktion auf das veränderte Ansteuersignal (30) kodierenden Referenz (52) durchführbar ist und
wobei mittels der Prüfvorrichtung (40) in Abhängigkeit vom Ergebnis des Vergleichs ein Statussignal (56) generierbar ist, welches die Funktionsfähigkeit des Schaltorgans (10) kodiert,
**dadurch gekennzeichnet,**
**dass** ein SiC-Leistungshalbleiter oder ein GaN-Leistungshalbleiter als Schaltelement (14) fungiert, wobei der SiC-Leistungshalbleiter oder GaN-Leistungshalbleiter mittels des Abschaltpulses (46) abschaltbar ist, während dieser in Rückwärtsrichtung Strom führt,
wobei die Prüfvorrichtung (40) eingerichtet ist, den SiC-Leistungshalbleiter oder GaN-Leistungshalbleiter mittels des Abschaltpulses (46) abzuschalten, während dieser in Rückwärtsrichtung Strom führt.

## Claims

1. Method for automatically testing the functionality of a switching member (10) comprising at least one electrically switchable switching element (14),
wherein a switching state of the or each switching element (14) is influenced via a control input (16) of the switching element (14) and by means of a control signal (30) generated by a control unit (12) and output to the control input (16),
wherein an activation signal (44) is output to the control unit (12) and changes the control signal (30), wherein the activation signal (44) induces a test signal (46) as the change to the control signal (30) and induces a disconnection pulse (46) as the test signal (46),
wherein in response to the disconnection pulse (46), the voltage drop across the switching element (14) is recorded,
wherein a comparison is carried out between an indicator (50) encoding the recorded voltage drop across the switching element (14) and a reference (52) encoding an expected response to the disconnection pulse (46), and
wherein depending on the result of the comparison, a status signal (56) is generated which encodes the functionality of the switching member (10),
**characterized in that**
a SiC power semiconductor or a GaN power semiconductor acts as the switching element (14), wherein the SiC power semiconductor or GaN power semiconductor is switched off by means of the disconnection pulse (46) while the former conducts current in the reverse direction.

2. Test device (40) for automatically testing the functionality of a switching member (10) comprising at least one electrically switchable switching element (14),
wherein a switching state of the or each switching element (14) can be influenced via a control input (16) of the switching element (14) and by means of a control signal (30) that can be generated by a control unit (12) and is output to the control input (16),
wherein the test device (40) can output an activation signal (44) to the control unit (12) which changes the control signal (30), wherein the activation signal (44) induces a test signal (46) as the change to the control signal (30) and induces a disconnection pulse (46) as the test signal (46),
wherein in response to the disconnection pulse (46), the test device (40) can record the voltage drop across the switching element (14),
wherein the test device (40) can carry out a comparison between an indicator (50) encoding the recorded voltage drop across the switching element (14) and a reference (52) encoding an expected response to the modified control signal (30), and
wherein depending on the result of the comparison, the test device (40) can generate a status signal (56) which encodes the functionality of the switching member (10),
**characterized in that**
an SiC power semiconductor or a GaN power semiconductor functions as the switching element (14), wherein the SiC power semiconductor or the GaN power semiconductor can be switched off by means of the disconnection pulse (46) while the former conducts current in the reverse direction,
wherein the test device (40) is configured to switch off the SiC power semiconductor or GaN power semiconductor by means of the disconnection pulse (46) while the former conducts current in the reverse direction.

## Revendications

1. Procédé de contrôle automatique de l'aptitude à fonctionner d'un organe (10) de coupure comprenant au moins un élément (14) de coupure pouvant être fermé électriquement,
dans lequel on influe sur un état de coupure du ou de chaque élément (14) de coupure par une entrée (16) de commande de l'élément (14) de coupure et au moyen d'un signal (30) de commande créé par une unité (12) de commande et donné à l'entrée (16) de commande,
dans lequel on donne à l'unité (12) de commande un signal (44) d'activation, qui provoque une modification du signal (30) de commande, dans lequel le signal (44) d'activation donne naissance comme modification du signal (30) de commande à un signal (46) de contrôle et comme signal (46) de contrôle à une impulsion (46) de blocage,
dans lequel on détecte comme réaction à l'impulsion (46) de blocage la chute de tension aux bornes de l'élément (14) de coupure,
dans lequel on effectue une comparaison entre un critère (50) codant la chute de tension détectée aux bornes de l'élément (14) de coupure et une référence (52) codant une réaction escomptée à l'impulsion (46) de blocage et
dans lequel on créé en fonction du résultat de la comparaison un signal (56) de statut, qui code l'aptitude à fonctionner de l'organe (10) de coupure,
**caractérisé en ce qu'**
un semi-conducteur de puissance au SiC ou un semi-conducteur de puissance au GaN sert d'élément (14) de coupure, dans lequel on bloque le semi-conducteur de puissance au SiC ou le semi-conducteur de puissance au GaN, au moyen de l'impulsion (46) de blocage, pendant que celui-ci conduit du courant dans le sens inverse.

2. Dispositif (40) de contrôle pour le contrôle automatique de l'aptitude à fonctionner d'un organe (10) de coupure comprenant au moins un élément (14) de coupure pouvant être fermé électriquement,
dans lequel un état de coupure du ou de chaque élément (14) de coupure peut être influencé par une entrée (16) de commande de l'élément (14) de coupure et au moyen d'un signal (30) de commande pouvant être créé par une unité (12) de commande et donné à l'entrée (16) de commande,
dans lequel, au moyen du dispositif (40) de contrôle, il peut être donné à l'unité (12) de commande un signal (44) d'activation, qui provoque une modification du signal (30) de commande, dans lequel le signal (44) d'activation donne naissance comme modification du signal (30) de commande à un signal (46) de contrôle et comme signal (46) de contrôle à une impulsion (46) de blocage,
dans lequel, au moyen du dispositif (40) de contrôle, comme réaction à l'impulsion (46) de blocage, la chute de tension aux bornes de l'élément (14) de coupure peut être détectée,
dans lequel, au moyen du dispositif (40) de contrôle, une comparaison entre un critère (50) codant la chute de tension détectée aux bornes de l'élément (14) de coupure et une référence (52) codant une réaction escomptée sur le signal (30) de commande modifié peut être effectuée, et
dans lequel, au moyen du dispositif (40) de contrôle, en fonction du résultat de la comparaison, peut être créé un signal (56) de statut, qui code l'aptitude à fonctionner de l'organe (10) de coupure,
**caractérisé en ce qu'**
un semi-conducteur de puissance au SiC ou un semi-conducteur de puissance au GaN sert d'élément (14) de coupure, dans lequel le semi-conducteur de puissance au SiC ou le semi-conducteur de puissance au GaN est bloqué au moyen de l'impulsion (46) de blocage, pendant que celui-ci conduit du courant dans le sens inverse,
dans lequel le dispositif (40) de contrôle est agencé pour bloquer le semi-conducteur de puissance au SiC ou le semi-conducteur de puissance au GaN au moyen de l'impulsion (46) de blocage, pendant que celui-ci conduit du courant dans le sens inverse.
